# EUROPÄISCHE PATENTSCHRIFT

(11) **EP 2 901 554 B1**
(45) Veröffentlichungstag und Bekanntmachung des Hinweises auf die Patenterteilung: **11.11.2020**
(21) Anmeldenummer: 13765706.0
(22) Anmeldetag: 18.09.2013
(51) Int. Cl.: H03K 17/968, F24C 7/08, G05G 1/08

(54) **EINGABEVORRICHTUNG FÜR ELEKTROGERÄT**
INPUT DEVICE FOR AN ELECTRICAL DEVICE
DISPOSITIF D'ENTRÉE POUR UN APPAREIL ÉLECTRIQUE

(30) Priorität: 26.09.2012 DE 102012217347
(43) Veröffentlichungstag der Anmeldung: 05.08.2015
(73) Patentinhaber: BSH Hausgeräte GmbH, 81739 München (DE)
(72) Erfinder: BOTH, Marianne, 80801 München (DE); DACHS, Andreas, 84181 Neufraunhofen (DE); MAKHTYUK, Roman, 93087 Alteglofsheim (DE); MARTIN, Bernd, 83371 Stein an der Traun (DE); MAYER, Herbert, 93051 Regensburg (DE); SORG, Matthias, 83379 Wonneberg (DE)
(86) Internationale Anmeldenummer: PCT/EP2013/069376
(87) Internationale Veröffentlichungsnummer: WO 2014/048812

(56) Entgegenhaltungen:
- EP-A2- 0 797 227
- EP-A2- 1 258 878
- WO-A1-2004/019150
- CN-U- 201 699 676
- DE-A1- 10 218 294
- DE-A1-102007 003 012
- DE-A1-102009 000 388
- DE-A1-102010 063 188
- DE-B3-102004 013 947
- JP-A- H0 528 879
- US-A1- 2005 001 156

## Beschreibung

Die Erfindung bezieht sich auf eine Eingabevorrichtung für ein Elektrogerät.

Eingabevorrichtungen werden an Elektrogeräten benötigt, um Sollbedingungen des Geräts vorzugeben. Bei einem Gargerät gehören zu den Sollbedingungen, die Temperatur des Garraums, die Auswahl von Garbedingungen, wie Oberhitze, Unterhitze, Benutzung des Lüfters und dergleichen und bei einem Kochfeld die Auswahl von Kochzonen und deren Temperatur.

Herkömmlich werden bei Elektrogeräten Schalter mit einer drehbaren Achse verwendet, wobei ein Betätiger am Ende der Achse befestigt ist und das Gerät die Drehung des Betätigers als einen Eingabebefehl interpretiert. Bekannt ist auch ein optischer Drehwinkelgeber, wie aus DE 43 11 496 DE, der nach dem Reflektions- bzw. Lichtschrankenprinzip arbeitet und bei dem eine magnetische Rastung erzielt wird. Aus DE 10 2006 062 071 B4 ist eine optische Eingabevorrichtung bekannt, die das von einer Lichtquelle ausgehende Licht mehrfach refraktiv umlenkt und die Eingabe einer Handbewegung auf einer Bedienfläche ausliest.

Die DE 10 2007 003 012 A1 beschreibt ein Bedienelement, welches über eine Drucktaste und einen Drehring verfügt. Um eine zuverlässige Erfassung des Verdrehens des Drehrings zu ermöglichen, ist der Drehring rastbar und das Verdrehen mit einer optischen Messeinrichtung erfassbar. An einem Rastenring sind dafür Prismenpaare angeordnet.
Die DE 10 2010 0631 88 A1 offenbart eine Bedienvorrichtung für ein Hausgerät mit einem elektronischen Anzeigefeld und einem ringförmigen Bedienelement. Ein ringförmiges Vorderteil ist dabei relativ zu einer Abdeckung drehbar und weist Magnete auf, deren Bewegung durch eine Wechselwirkung mit feststehenden Metallelementen durch die Bedienvorrichtung erfassbar ist.

Die CN 201 699 676 U offenbart eine Drehknopf-Schalteinheit mit einem drehbaren Betätigungsknopf sowie mit einem Infrarotsender und einem Infrarotempfänger. Der Betätigungsknopf weist mehrere mit dem Infrarotsender und dem Infrarotempfänger korrespondierende Kammern auf, wovon einige eine Abtrennung aufweisen. Ist eine durch eine Abtrennung aufgeteilte Kammer über dem Infrarotsender und dem Infrarotempfänger angeordnet, blockiert die Abtrennung einen mittels des Infrarotsenders emittierten Lichtstrahl. Ist eine abtrennungsfreie Kammer über dem Infrarotsender und dem Infrarotempfänger angeordnet, wird der Lichtstrahl an einer inneren Oberfläche der Kammer reflektiert und trifft auf den Infrarotempfänger.

Aufgabe der vorliegenden Erfindung ist es, die bekannten Ausführungsformen der Eingabevorrichtungen zu verbessern. Dabei soll ein möglichst einfach aufgebautes System bereitgestellt werden, das einfach gereinigt werden kann und das tolerant gegenüber Verschmutzungen ist. Ferner soll der Anwender ein Feedback über eine erfolgte Eingabe erhalten.

Diese Aufgabe wird durch Anspruch 1 gelöst. Vorteilhafte Weiterbildungen ergeben sich aus den Unteransprüchen.

Eine Eingabevorrichtung für ein Elektrogerät weist eine an dem Gerät anbringbare Basis und einen relativ zur Basis beweglichen Eingabebetätiger auf. Dabei umfasst die Basis mindestens eine Lichtquelle zur Erzeugung eines Messstrahls und mindestens einen Sensor zur Detektion des reflektierten Messstrahls und der Eingabebetätiger umfasst eine Vielzahl von Reflektionskörpern zur Reflektion des Messstrahls auf den Sensor, wobei jeder Reflektionskörper eine Eintrittsfläche zum Eintritt des Messstrahls in den Reflektionskörper, zumindest eine Reflektionsfläche zur Reflektion des Messstrahls und eine Austrittsfläche zum Austritt des Messstrahls aus dem Reflektionskörper aufweist. Die Strahlablenkung innerhalb eines Prismas wird als eine Reflektion verstanden. Insbesondere ergibt sich aus diesem Aufbau, dass der Strahl bei der Reflektion innerhalb des Materials geführt wird und dies bedeutet, dass Verschmutzungen der Reflektionsoberfläche keinen Einfluss oder nur einen reduzierten Einfluss auf die Reflektionsqualität haben.

Die Reflektionskörper sind integral in einem Träger bzw. einem gemeinsamen Reflektionsring verbunden. Dieser kann ein kostengünstiges Spritzgussteil sein, wodurch sichergestellt wird, dass die Reflektionskörper stets exakt und korrekt zueinander positioniert sind.

Die Eintrittsfläche und die Austrittsfläche sind bevorzugt so ausgerichtet, dass der Messstrahl im Wesentlichen senkrecht auf die Eintrittsfläche trifft und den Reflektionskörper im Wesentlichen senkrecht zur Austrittsfläche verlässt. Es wurde erkannt, dass beim Eintritt des Messstrahls unerwünschte Reflektionen an der Kontaktfläche reduziert werden können, wenn der Strahl senkrecht auf die Oberfläche trifft. Auch im Fall von Verschmutzungen wird der Strahlengang dann weniger gestört, wenn die Strahlrichtung senkrecht zu der entsprechenden Oberfläche ausgerichtet ist.

In einer bevorzugten Ausführungsform liegen die Eintrittsfläche und die Austrittsfläche in der gleichen Ebene, da sich hierdurch eine größere gemeinsame und ebene Fläche ergibt, die in einem einzigen gemeinsamen Arbeitsschritt gereinigt werden kann. Außerdem wird so die Anzahl der Ecken und Kanten und damit die Möglichkeiten der Anlagerung von Verschmutzungen reduziert.

Insbesondere sind die Reflektionskörper zur Erkennung einer Drehbewegung des Eingabebetätigers kreisförmig angeordnet, da hiermit eine Bewegungsbahn ohne einen Anfang und ohne ein Ende geschaffen wird, was beispielsweise für einen Inkrementalwertgeber vorteilhaft ist.

Weiterführend weist die Basis zumindest einen Magneten auf und der Eingabebetätiger weist eine Vielzahl von metallischen Abschnitten auf. Dabei wird für eine Eingabe mit der Eingabevorrichtung eine Bewegungsbahn der metallischen Abschnitte relativ zu dem Magneten definiert und ein rastungsähnliches haptisches Feedback wird bewirkt.

Weiterführend weist die Basis eine beim Anbau der Eingabevorrichtung in Richtung des Geräteäußeren zeigende Sichtoberfläche und eine gegenüber der Sichtoberfläche in Richtung des Geräteinneren abgesetzte Freimachung für den Eingabebetätiger auf. Dabei sind die metallischen Abschnitte komplett in der Freimachung aufgenommen und insbesondere sind die Reflektionskörper zu mindestens 60% und insbesondere komplett in der Freimachung aufgenommen. So wird der Eingabebetätiger weitestgehend in der Front des Geräts integriert und es ergibt sich ein angenehmes Gesamtdesign.

Die Basis weist bevorzugt eine beim Anbau der Eingabevorrichtung in Richtung des Geräteäußeren zeigende Sichtoberfläche auf, wobei der Eingabebetätiger in seiner Gesamtheit nicht weiter als 10 mm von der Sichtoberfläche in Richtung des Geräteäußeren liegt. Auch hierdurch wird der Gesamteindruck verbessert und die Gefahr, dass man an vorstehenden Teilen hängen bleibt, ist deutlich reduziert.

Bevorzugt ist in einem Raum zwischen zwei benachbarten metallischen Abschnitten zumindest ein Teil eines Reflektionskörpers angeordnet und insbesondere ist dort zumindest ein Teil einer der Reflektionsflächen des Reflektionskörpers angeordnet. Da die Anzahl der Reflektionsflächen identisch ist zu der der metallischen Abschnitte, kann der Raum auf diese Art besser genutzt werden und es ergibt sich für den Eingabebetätiger eine geringe Bauhöhe.

Weiterführend wird der Eingabebetätiger derart mit Magnetkräften an der Basis gehalten, dass er ausschließlich durch Überwindung der magnetischen Haltekräfte und ohne Lösen eines weiteren Befestigungselements von der Basis entfernt werden kann, wodurch die Reinigung sowohl des Eingabebetätigers als auch dessen Aufnahme vereinfacht wird.

Im Folgenden wird die Erfindung mit Bezug auf die Zeichnungen anhand von bevorzugten Ausführungsformen beispielhaft beschrieben. Es zeigen:
- Fig. 1: eine perspektivische Ansicht eine Gargeräts mit einer Eingabevorrichtung,
- Fig. 2: einen Querschnitt durch die Eingabevorrichtung,
- Fig. 3: eine Explosionsansicht des Eingabebetätigers der Eingabevorrichtung,
- Fig. 4: eine perspektivische Ansicht des Reflektionsrings und
- Fig. 5: einen zweiten Querschnitt durch die Eingabevorrichtung.

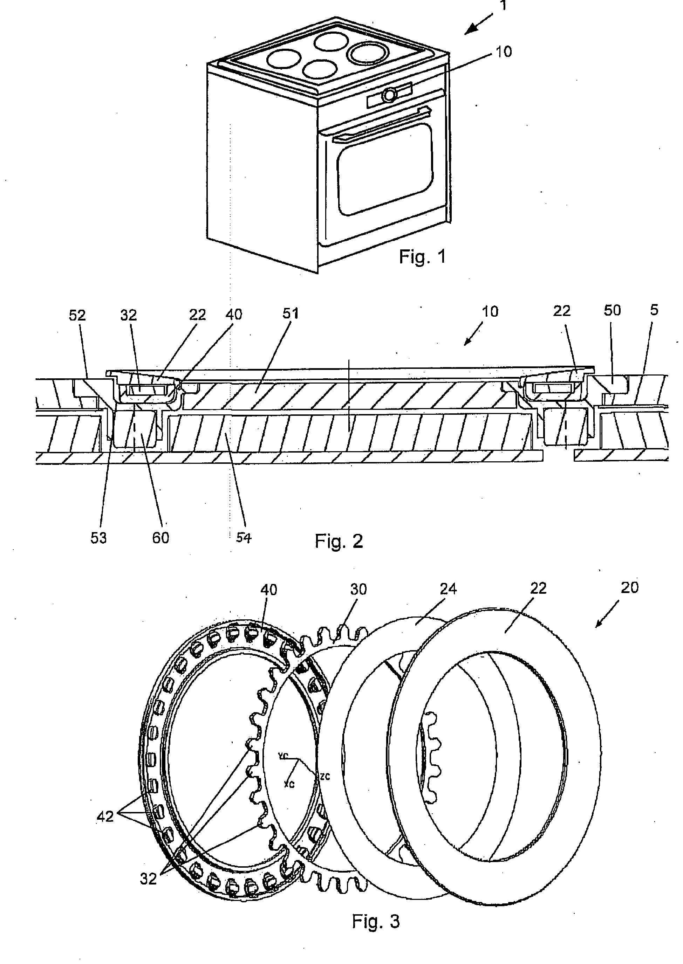

Fig. 1 zeigt im Allgemeinen ein Elektrogerät 1 und insbesondere einen Backofen. An der nach vorne gerichteten Vertikalfläche ist eine Eingabevorrichtung 10 angebracht. Fig. 2 zeigt einen horizontalen Schnitt durch die Vorderseite des Gargeräts. Dabei hat das Gerät eine Frontplatte 5, in die die Eingabevorrichtung 10 eingelassen ist. Die Eingabevorrichtung 10 weist eine Basis 50 auf, die ortsfest und dauerhaft mit der Frontplatte verbunden, wie bspw. verschraubt oder verklipst ist. Die Basis 50 hat eine kreisförmige umlaufende Freimachung 53 mit einem U-förmigen Querschnitt. Der U-förmige Querschnitt hat einen Grundbereich, der parallel zu der Außenseite der Frontplatte 5 liegt und zu beiden Seiten von in etwa senkrechten Flanken begrenzt wird, wobei im Übergang Rundungen vorgesehen sind. In dieser Freimachung 53 ist ein Großteil des Eingabebetätigers 20 aufgenommen.

Der Eingabebetätiger 20 besteht, wie Fig. 3 zeigt, aus vier Komponenten, nämlich einem Reflektionsring 40, einem Rastring 30 aus einem ferromagnetischen Werkstoff und einer Verklebung 24 mit einer Sichtblende 22. Der Rastring 30 ist matt schwarz lackiert oder eloxiert, um unbeabsichtigte Reflektionen des Lichtstrahls zu vermeiden.

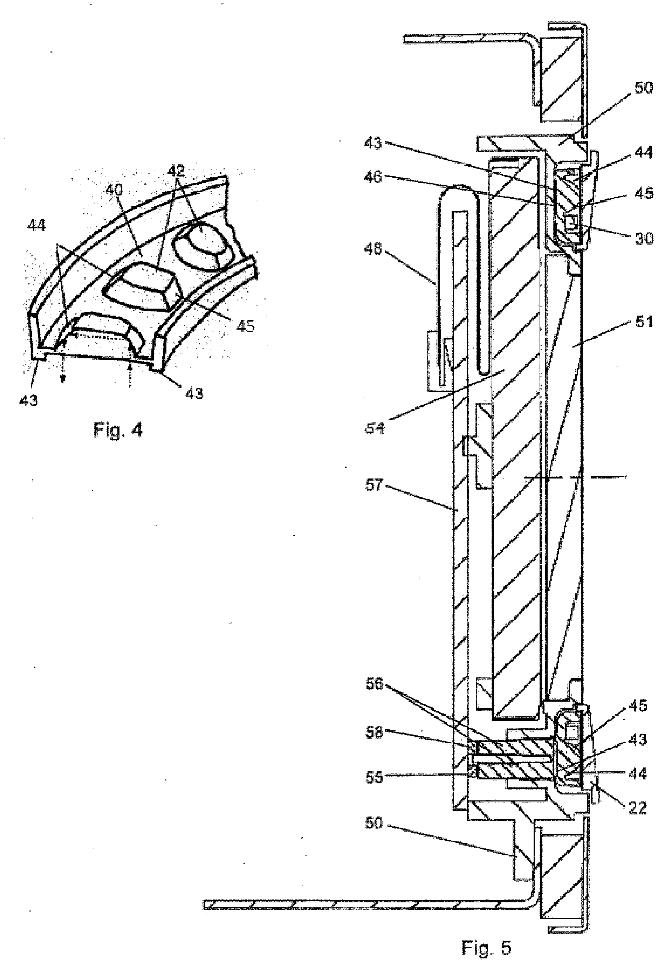

Der Reflektionsring 40 ist ein Spritzgussteil aus einem durchsichtigen klaren Kunststoff, wie beispielsweise PMMA (Polymethylmethacrylat), PC (Polycarbonat), PS (Polystyrol), COC (Cycloolefine-Co-Polymere), COP (Cycloolefine-Polymere) oder SAN (Styrol-Acrylnitrilcopolymere). Wie aus Fig. 3 und 4 ersichtlich ist, weist der Reflektionsring 40 eine ringförmige, ebene Grundfläche 41 auf, die an ihrer einen Seite zwei von der Seite sich erhebende, kurze, den Ring umlaufende Erhöhungen aufweist, die als Kontaktflächen 43a zur Auflage und als Gleitfläche entlang der Freimachung 53 dienen. Zur ihrer anderen Seite weist die Grundfläche 41 eine innenliegende und eine außenliegende ringförmige Wand auf, die dafür sorgen, dass der Reflektionsring 40 im Schnitt eine U-förmige Kontur hat.

Diese U-förmige Kontur dient als Aufnahme für den Rastring 30. Dieser Rastring 30 umfasst einen kreisförmig umlaufenden Steg, von dem radial nach außen stehend und gleichmäßig verteilt, eine Vielzahl von metallischen Abschnitten 32 ausgeht. Der Rastring 30 ist ein ebenes Stanzteil gleichmäßiger Dicke von ca. 1 mm aus einer ferromagnetischen Eisenlegierung. Die metallischen Abschnitte 32 haben eine Breite von ca. 2 mm, so dass die Abstände zwischen den Abschnitten 32 etwas breiter sind, als die Abschnitte 32 selbst. Wenn der Rastring 30 in die U-förmige Kontur des Reflektionsrings 40 gelegt wird, so befinden sich die an dem Reflektionsring 40 angeformten Reflektionskörper 42 in den genannten Abständen. Diese haben eine radial ausgerichtete trapezförmige Kontur, wobei deren schrägen Flanken in einem Winkel von 45° zur Grundfläche 41 stehen. Die Sichtblende 22 ist ein gedrehter oder tiefgezogener Ring aus Edelstahl, wie bspw. dem Werkstoff 1.4305. Alternativ kann sie aus einem hochwertigen oder metallbeschichteten Kunststoff gefertigt sein. Die zwischen der Sichtblende 22 und dem Reflektionsring 40 gezeigte Verklebung 24 kann als eine doppelseitige Klebefolie ausgeführt sein oder steht symbolisch für das Einbringen eines flüssigen Klebers in diesen Bereich. Auch eine unlösbare Verbindung von Ringoberteil (Sichtblende 22) und Ringunterteil (Reflektionsring 40) durch das Verschweißen des Kunststoffringes bzw. Reflektionsrings 40 mit einer rauen Oberfläche des Edelstahls der Sichtblende 22 ist denkbar.

Die Basis 50 dient als Träger für zwei Magnete 60, die von der Freimachung 53 aus geräteinnenseitig angeordnet sind, um in magnetischen Wirkkontakt sowohl mit den metallischen Abschnitten 32 als auch mit dem umlaufenden Steg des Rastrings 30 zu treten. Die Magnete 60 haben eine Einsatztemperatur von mindestens 120°C. Bei dem Drehen des Eingabebetätigers 20 werden die umlaufend 30 Abschnitte 32 nacheinander von den Magneten 60 angezogen, was für den Anwender den haptischen Eindruck einer Rastung bewirkt, und wodurch er das Feedback erhält, dass eine Eingabe bewirkt wurde. Außerdem sorgen die metallischen Abschnitte 32 in Verbindung mit dem umlaufenden Steg dafür, dass der Eingabebetätiger 20 in der Freimachung 53 verbleibt. Da die Flanken der U-förmigen Freimachung 53 senkrecht zur Gerätefront sind, müssen die Magnete 60 nicht die gesamten Gewichtskräfte des Eingabebetätigers 20 halten können, sondern der Eingabebetätiger 20 kann auf den Flanken aufliegen. Vielmehr müssen die Magnete 60 lediglich dafür sorgen, dass der Eingabebetätiger 20 am Grund der Freimachung 53 gehalten wird. Bei der Verwendung von 2 Magneten 60 ergibt sich eine Abzugkraft von 1 N, wobei diese Kraft durch stärkere Magnete oder eine Erhöhung der Magnetenanzahl gesteigert werden kann.

Wie sich aus Fig. 5 ergibt, dient die Basis 50 als Träger für zwei Platinen, nämlich die Hauptplatine 57 und die damit über ein Flachbandkabel 48 verbundene Anzeigeplatine 54. Die Anzeigeplatine 54 ist mit einer relativ breiten Fläche schematisch angedeutet und beinhaltet eine normale Platine als Träger und darauf angebrachte Displayelemente, wie bspw. ein LED- oder LCD-Display. Die Hauptplatine 57 dient als Träger für die Lichtquelle 55 und den Sensor 58. Die Lichtquelle 55 ist eine LED, die in einem Öffnungswinkel von 60° gegen ihre optische Achse Licht ausstrahlt. Sowohl sichtbares Licht, als auch infrarotes Licht ist prinzipiell verwendbar. Unmittelbar gegenüber der Lichtquelle 55 ist ein Lichtleiter 56 angeordnet, der ein Spritzgussteil ist und eine leicht konische Form aufweist. Die konische Form ist bedingt durch die Ausformschräge im Kunststoffspritzwerkzeug und weniger zur Bündelung der Lichtstrahlen. Der Lichtleiter 56 wird für die Lichtführung von der IR-LED als Sender hin zum Reflektionsring 40 verwendet. Im Reflektionsring 40 wird zur Reflektion das Prinzip der Strahlumlenkung in einem Prisma verwendet und es werden hierfür bevorzugt keine verspiegelten Oberflächen verwendet, wobei verspiegelte Oberflächen auch verwendbar wären. Die optische Funktion wird somit als eine Prismenumlenkung verstanden, die das gesendete Licht zurück zum Phototransistor als Empfänger umlenkt. Der Lichtleiter 56 ist im Durchmesser so gewählt, dass dieser nahezu 100 % des abgestrahlten Lichts einfangen und zur Prismenumlenkung führt. Die Lichtleiterlänge ist dabei theoretisch frei wählbar, da im Lichtleiter 56 selbst durch die Totalreflexion keine Lichtverluste entstehen. Lichtverluste entstehen an den optischen Grenzflächen, d. h. den Lichteintrittsflächen in Lichtleiter 56 und Reflektionsring 40 durch Teilreflexion, und an den Umlenkflächen 44, 45 des Prismas bzw. Reflektionskörpers 42 durch Lichtverluste.

Die Lichtleitermitten sind idealerweise jeweils genau im Ellipsenbrennpunkt des ellipsenförmigen Prismas, also der gekrümmten Umlenkfläche 44, 45, angeordnet, was in der Praxis wegen der auftretenden Toleranzen nicht möglich ist. Da eine Ellipse zwei Brennpunkte hat, ist der Lichtleiter 56 als Sendelichtleiter einem der Brennpunkte und ein anderer Lichtleiter 56 als Empfängerlichtleiter dem gegenüberliegenden zweiten der Brennpunkte zugeordnet. Die Brennpunkte sind dabei beliebig austauschbar, so dass der Empfängerbrennpunkt auch der Senderbrennpunkt sein könnte und umgekehrt. Um Fertigungs- und Montagetoleranzen auszugleichen ist das Prisma 42 so konstruiert, dass es Toleranzen bis ca. +/- 0,6 mm kompensieren kann. Die Umlenkflächen 44, 45 sind deshalb als mehrfach gekrümmte Flächen am Prisma bzw. Reflektionskörper 42 ausgebildet, die über die Toleranzzone das Licht zuverlässig umlenken. Bei einer theoretisch genauen Lage des Lichtleitermittelpunktes zum Ein- bzw. Auskoppelpunkt wäre eine plane 45° Umlenkfläche ausreichend. Auch müsste dann das Prisma nicht als Ellipse ausgeführt werden, sondern es würde ein gerader, d. h in der Seitenansicht rechteckförmiger Lichtleiter genügen. Der Lichtleiter 56 endet bündig mit dem Grund der Freimachung 53 und in dessen Verlängerung liegt der Prismenring bzw. Reflektionsring 40 und abhängig von dessen winkelgemäßer Ausrichtung ein Prisma 42 oder Reflektionskörper 42. Die Magnete 60 sind so in Bezug auf die metallischen Abschnitte 32 ausgerichtet, dass sie die Prismen bzw. Reflektionskörper 42 aufgrund der Magnetkraft zu der Lichtquelle 55 und dem Sensor 58 ausrichten.

Das Licht der Lichtquelle 55 wird durch den Lichtleiter 56 zu dem Grund der Freimachung 53 geleitet und von dort über einen geringen Luftspalt durch die Eintrittsfläche 43 in einen der Reflektionskörper 42. Innerhalb des Reflektionskörpers 42 wird es an die erste 90°-Umlenkfläche bzw. Reflektionsfläche 44 geleitet, dort innerhalb des Materials in Form einer Lichtumlenkung bzw. Totalreflektion so umgelenkt, dass es auf die zweite 90°-Umlenkfläche bzw. Reflektionsfläche 45 trifft. Dort wird das Licht ebenfalls innerhalb des Materials umgelenkt, so dass es den Reflektionsring 40 durch die Austrittsfläche 46 verlässt und über den anderen Lichtleiter 56 zu dem Sensor 58 geleitet wird. Dabei sind bevorzugt die Ein- und Austrittwinkel für den Lichtstrahl, bei denen es sowohl in die Lichtleiter 56 als auch in das jeweilige Prisma bzw. in den jeweiligen Reflektionskörper 42, bzw. in den Prismenring oder Reflektionsring 40 ein- oder austritt, in einem rechten Winkel zu der optischen Achse, um dort eine Strahl-(teil)reflektion möglichst gering zu verhindern oder zu minimieren.

Neben der bereits beschriebenen Lichtquelle 55, den Lichtleitern 56 und dem Sensor 58 sind zudem ein entsprechendes zweites Paar dieser Elemente an der Hauptplatine 57 vorgesehen und dabei um den Winkel n ^{∗} h + 1/3 h gegenüber dem ersten Paar versetzt, wobei n eine natürliche Zahl und h der Abstand bzw. Winkelversatz von zwei benachbarten Reflektionskörpern 42 ist. Hier ist auch jede andere ungerade Teilung denkbar. Bedingung ist nur, dass die Umlenkung nicht für beide Sensorpaare gleichzeitig in Deckung kommen kann, um eine Drehrichtungsauswertung sicherzustellen. Dies gilt auch für das mögliche Übersprechen von einem Sensor 58 zum anderen. Um dies auszuschließen, sind die Sensorpaare möglichst weit auseinander angeordnet oder gegensinnig nebeneinander anzuordnen. Hier ist auch eine zeitunterschiedliche Taktung (Multiplexansteuerung) der Sensoren 58 möglich. Wenn der Eingabebetätiger 20 gedreht wird, so werden die Sensoren 58 jeweils zeitversetzt den Lichtstrahl detektieren. Über die Geschwindigkeit der Detektionen kann die Drehgeschwindigkeit des Eingabebetätigers 20 und über den zeitlichen Versatz der Detektionssignale der beiden Sensoren 58 kann die Drehrichtung erkannt werden. So kann beispielsweise einem Gargerät der Befehl der Temperaturerhöhung gegeben werden. Ein Display, dass in der Anzeigeplatine 54 integriert ist, ist durch die Verglasung 51 sichtbar und so erhält der Anwender durch eine Erhöhung oder Verringerung von einer angezeigten Solltemperatur ein Feedback über seine Eingaben. Zusätzlich spürt er den rastenähnlichen Widerstand der Magnete 60.

Da die Lichtleiter 56 bündig und spaltfrei in die Freimachung 53 eingepasst und dort ggf. verklebt sind und da für die Magnetrastungen kein Durchbruch in der Freimachung 53 notwendig ist, bildet die Freimachung 53 eine umlaufend absatzfreie Vertiefung, die im Fall von Verschmutzungen leicht gereinigt werden kann. Auch sind die Ein- und Austrittsfläche des Lichtstrahls in und aus dem Reflektionsring 40 in derselben Ebene, die einfach gereinigt werden kann. Falls dennoch Verschmutzungen im Bereich des optischen Pfads des Lichtstrahls sein sollten, so sind diese bei der beschriebenen senkrechten Ausrichtung deutlich weniger schädlich, als dies bei einer schrägwinkligen Reflektion gegeben wäre. Da der Eingabebetätiger 20 lediglich durch die Magnetkräfte an der Basis 50 gehalten wird, kann er von dem Anwender für die Reinigung leicht entnommen werden.

Bei der beschriebenen Ausführungsform ist ein Großteil des Eingabebetätigers 20 von der Sichtoberfläche 52 in Richtung zum Geräteinneren versetzt. Es steht praktisch nur ein Teil von der Sichtblende 22 als Eingabemöglichkeit gegenüber der Sichtoberfläche 52 vor. Dadurch wird ein ansprechendes Design geschaffen.

Da die Reflektion innerhalb des Körpers bzw. Materials des Reflektionskörpers 42 stattfindet und zusätzlich die Außenflächen der Reflektionsflächen 44 und 45 innerhalb des geschlossenen Raums liegen, der sich dadurch bildet, dass der Reflektionsring 40 mit dem Eingabebetätiger 20 verklebt ist, können sich an den Außenflächen der Reflektionsflächen 44 und 45 keine Verschmutzungen ansammeln und so wird die Reflektion an diesen Flächen stets unabhängig von Verschmutzungen ermöglicht. Eine gute Reflektion und ein niedriger Verlust der Lichtleistung bei den Grenzflächenübergängen ist notwendig, um am Sensor 58 eine ausreichende Lichtmenge zu erhalten und um so die Bewegung des Eingabebetätigers 20 sicher erkennen zu können.

Zusätzlich sind bei der Eingabevorrichtung 1 Eingabetasten (nicht dargestellt) vorgesehen, mit denen über den Eingabebetätiger 20 vorgenommene Eingaben bestätigt werden können, oder mit denen spezielle Menüpunkte einer über die Anzeige dargestellten Benutzerführung ausgewählt werden können.

Der Außendurchmesser des Eingabebetätigers 20 beträgt 60 mm +/- 10 mm und hat eine Breite von 15 mm +/- 5 mm, so dass der Anwender den Eingabebetätiger 20 bequem mit einem Finger über Kontakt mit der Außenfläche der Sichtblende 22 drehen kann. Dabei hat die Sichtblende 22 einen umlaufenden Rand, der größer ist, als der Außendurchmesser der Freimachung 53, so dass der Anwender den Spalt zwischen der Freimachung 53 und dem Reflektionsring 40 nicht sieht und um das Eindringen von Verschmutzungen in diesen Spalt zu verhindern.

Bislang wurde eine bevorzugte Ausführungsform mit zwei Lichtquellen-Sensor-Paarungen beschrieben, mit dem in Form eines Inkrementalgebers Drehungen und Drehrichtungen erkannt werden können. Wenn die Anzahl der Lichtquellen-Sensor-Paarungen deutlich, wie bspw. auf 8 oder 10, vergrößert und nach einer vorgegebenen Logik am Reflektionsring teilweise auf Reflektionskörper 42 verzichtet wird, so ergibt sich ein Absolutwertgeber, bei dem die exakte bzw. absolute Winkellage des Eingabebetätigers 20 erkannt wird. Vorstehend wurde ein ringförmiger Eingabebetätiger 20 beschrieben. Die beschriebenen Prinzipien der Erfindung lassen sich entsprechend auf einen gradlinigen Eingabebetätiger anwenden, der entlang einer Linearbahn geführt wird.

## Patentansprüche

1. Eingabevorrichtung (10) für ein Elektrogerät (1) mit einer an dem Gerät anbringbaren Basis (50) und einem relativ zur Basis beweglichen Eingabebetätiger (20), wobei die Basis mindestens eine Lichtquelle (55) zur Erzeugung eines Messstrahls und mindestens einen Sensor (58) zur Detektion des reflektierten Messstrahls aufweist, und der Eingabebetätiger (20) eine Vielzahl von Reflektionskörpern (42) zur Umlenkung des Messstrahls auf den Sensor (58) umfasst,
wobei jeder Reflektionskörper (42) eine Eintrittsfläche (43) zum Eintritt des Messstrahls in den Reflektionskörper (42), zumindest eine Reflektionsfläche (44, 45) zur Reflektion des Messstrahls und eine Austrittsfläche (46) zum Austritt des Messstrahls aus dem Reflektionskörper (42) aufweist,
**dadurch gekennzeichnet, dass**
eine Mehrzahl der Reflektionskörper (42) einstückig in einem Träger integriert ist, sodass ein Reflektionsring (40) als ein Spritzgussteil ausgebildet ist, und wobei der Eingabebetätiger (20) ringförmig ist.

2. Eingabevorrichtung (10) gemäß Anspruch 1, wobei die Eintrittsfläche (43) und die Austrittsfläche (46) so ausgerichtet sind, dass der Messstrahl senkrecht auf die Eintrittsfläche (43) trifft und den Reflektionskörper (42) im Wesentlichen senkrecht zur Austrittsfläche (46) verlässt.

3. Eingabevorrichtung (10) gemäß Anspruch 1 oder 2, wobei die Eintrittsfläche (43) und die Austrittsfläche (46) in der gleichen Ebene liegen.

4. Eingabevorrichtung (10) gemäß einem der vorangegangenen Ansprüche, wobei die Reflektionskörper (42) zur Erkennung einer Drehbewegung des Eingabebetätigers (20) kreisförmig angeordnet sind.

5. Eingabevorrichtung (10) gemäß einem der vorangegangenen Ansprüche, wobei die Basis (50) zumindest einen Magneten (60) aufweist und der Eingabebetätiger (20) eine Vielzahl von metallischen Abschnitten (32) umfasst, und für eine Eingabe mit der Eingabevorrichtung (10) eine Bewegungsbahn der metallischen Abschnitte (32) relativ zu dem Magneten (60) zur Erzeugung eines rastungsähnlichen haptischen Feedbacks vorgesehen ist.

6. Eingabevorrichtung (10) gemäß Anspruch 5, wobei die Basis (50) eine beim Anbau der Eingabevorrichtung in Richtung des Geräteäußeren zeigende Sichtoberfläche (52) und eine gegenüber der Sichtoberfläche (52) in Richtung des Geräteinneren abgesetzte Freimachung (53) für den Eingabebetätiger (20) aufweist, wobei die metallischen Abschnitte (32) komplett in der Freimachung (53) aufgenommen sind und insbesondere die Reflektionskörper (42) zu mindestens 60% und bevorzugt komplett in der Freimachung (53) aufgenommen sind.

7. Eingabevorrichtung (10) gemäß einem der Ansprüche 5 oder 6, wobei in einem Raum zwischen zwei benachbarten metallischen Abschnitten (32) zumindest ein Teil eines Reflektionskörpers (42) und insbesondere zumindest ein Teil einer der Reflektionsflächen (44, 45) des Reflektionskörpers (42) angeordnet ist.

8. Eingabevorrichtung (10) gemäß einem der vorangegangenen Ansprüche, wobei die Basis (50) eine beim Anbau der Eingabevorrichtung (10) in Richtung des Geräteäußeren zeigende Sichtoberfläche (52) aufweist, und der Eingabebetätiger (20) komplett nicht weiter als 10 mm von der Sichtoberfläche in Richtung des Geräteäußeren liegt.

9. Eingabevorrichtung (10) gemäß einem der vorangegangenen Ansprüche, wobei der Eingabebetätiger (20) derart mit Magnetkräften an der Basis (50) gehalten wird, dass er ausschließlich durch Überwindung der magnetischen Haltekräfte und ohne das Lösen eines weiteren Befestigungselements von der Basis (50) entfernt werden kann.

## Claims

1. Input device (10) for an electrical device (1) with a base (50) which can be attached to the device and an input actuator (20) which can be moved in relation to the base, wherein the base has at least one light source (55) for producing a measurement beam and at least one sensor (58) for detecting the reflected measurement beam, and the input actuator (20) comprises a plurality of reflection bodies (42) for deflecting the measurement beam onto the sensor (58),
wherein each reflection body (42) has an entry area (43) for entry of the measurement beam into the reflection body (42), at least one reflection surface (44, 45) for reflecting the measurement beam and an outlet area (46) for outlet of the measurement beam from the reflection body (42),
**characterised in that**
a plurality of reflection bodies (42) is integrated in a bracket (44) in one piece, so that a reflection ring (40) is embodied as an injection-moulded part, and wherein the input actuator (20) is ring-shaped.

2. Input device (10) according to claim 1, wherein the entry area (43) and the outlet area (46) are aligned such that the measurement beam hits the entry area (43) vertically and leaves the reflection body (42) essentially vertically to the outlet area (46).

3. Input device (10) according to claim 1 or 2, wherein the entry area (43) and the outlet area (46) are on the same plane.

4. Input device (10) according to one of the preceding claims, wherein the reflection bodies (42) for detecting a rotating movement of the input actuator (20) are arranged in a circular pattern.

5. Input device (10) according to one of the preceding claims, wherein the base (50) has at least one magnet (60) and the input actuator (20) comprises a plurality of metallic sections (32), and for an input with the input device (10) a trajectory of metallic sections (32) relative to the magnet (60) is provided for producing a detent-like haptic feedback.

6. Input device (10) according to claim 5, wherein the base (50) has a viewing surface (52) facing in the direction of the exterior of the device when the input device is attached and offset clearance (53) opposite the viewing surface (52) in the direction of the interior of the device for the input actuator (20), wherein the metallic sections (32) are completely incorporated into the clearance (53) and in particular the reflection bodies (42) are incorporated into the clearance (53) by at least 60% and preferably completely.

7. Input device (10) according to one of claims 5 or 6, wherein at least one part of a reflection body (42) and in particular at least one part of one of the reflection surfaces (44, 45) of the reflection body (42) is arranged in a space between two adjacent metallic sections (32).

8. Input device (10) according to one of the preceding claims, wherein the base (50) has a viewing surface (52) facing in the direction of the exterior of the device when the input device (10) is attached and the complete input actuator (20) is not more than 10 mm from the viewing surface in the direction of the exterior of the device.

9. Input device (10) according to one of the preceding claims, wherein the input actuator (20) is held on the base (50) with magnetic forces such that it can only be removed from the base (50) by overcoming the magnetic retaining forces and without releasing a further anchoring element.

## Revendications

1. Dispositif d'entrée (10) pour un appareil électrique (1), comprenant une base (50) pouvant être placée sur l'appareil et un actionneur d'entrée (20) déplaçable par rapport à la base, dans lequel la base comprend au moins une source lumineuse (55) destinée à générer un faisceau de mesure, et au moins un capteur (58) pour la détection du faisceau de mesure réfléchi, et dans lequel l'actionneur d'entrée (20) comprend une pluralité de corps de réflexion (42) destinés à dévier le faisceau de mesure sur le capteur (58),
dans lequel chaque corps de réflexion (42) comprend une surface d'entrée (43) pour l'entrée du faisceau de mesure dans le corps de réflexion (42), au moins une surface de réflexion (44, 45) pour la réflexion du faisceau de mesure, et une surface de sortie (46) pour la sortie du faisceau de mesure hors du corps de réflexion (42),
**caractérisé en ce qu'**
une pluralité des corps de réflexion (42) est intégrée d'une seule pièce dans un support de sorte qu'un anneau de réflexion (40) est réalisé en tant qu'une pièce moulée par injection, et dans lequel l'actionneur d'entrée (20) est annulaire.

2. Dispositif d'entrée (10) selon la revendication 1, dans lequel la surface d'entrée (43) et la surface de sortie (46) sont orientées de manière à ce que le faisceau de mesure tombe perpendiculairement sur la surface d'entrée (43) et quitte le corps de réflexion (42) essentiellement perpendiculairement à la surface de sortie (46).

3. Dispositif d'entrée (10) selon la revendication 1 ou 2, dans lequel la surface d'entrée (43) et la surface de sortie (46) sont situées dans le même plan.

4. Dispositif d'entrée (10) selon l'une quelconque des revendications précédentes, dans lequel les corps de réflexion (42) sont disposés de manière circulaire dans le but d'identifier un mouvement de rotation de l'actionneur d'entrée (20).

5. Dispositif d'entrée (10) selon l'une quelconque des revendications précédentes, dans lequel la base (50) comprend au moins un aimant (60) et dans lequel l'actionneur d'entrée (20) comprend une pluralité de sections métalliques (32), et dans lequel, pour une entrée à l'aide du dispositif d'entrée (10), une voie de déplacement des sections métalliques (32) par rapport à l'aimant (60) est ménagée dans le but de générer une rétroaction tactile similaire à un encliquetage.

6. Dispositif d'entrée (10) selon la revendication 5, dans lequel la base (50) comprend une surface visible (52) orientée en direction de l'extérieur de l'appareil lors du montage du dispositif d'entrée, et un dégagement (53) pour l'actionneur d'entrée (20), décalé en direction de l'intérieur de l'appareil par rapport à la surface visible (52), dans lequel les sections métalliques (32) sont complètement logées dans le dégagement (53) et notamment les corps de réflexion (42) sont logés pour au moins 60% et, de préférence, complètement dans le dégagement (53).

7. Dispositif d'entrée (10) selon l'une quelconque des revendications 5 ou 6, dans lequel au moins une partie d'un corps de réflexion (42), et notamment au moins une partie de l'une des surfaces de réflexion (44, 45) du corps de réflexion (42), est disposée dans un espace entre deux sections métalliques (32) avoisinantes.

8. Dispositif d'entrée (10) selon l'une quelconque des revendications précédentes, dans lequel la base (50) comprend une surface visible (52) orientée en direction de l'extérieur de l'appareil lors du montage du dispositif d'entrée (10), et dans lequel l'actionneur d'entrée (20) est situé complètement en direction de l'extérieur de l'appareil pas plus loin que 10 mm de la surface visible.

9. Dispositif d'entrée (10) selon l'une quelconque des revendications précédentes, dans lequel l'actionneur d'entrée (20) est maintenu sur la base (50) au moyen de forces magnétiques de manière à ce qu'il puisse être retiré de la base (50) uniquement en surmontant les forces de maintien magnétiques et sans le détachement d'un élément de fixation supplémentaire.
